(19) Europäisches Patentamt
European Patent Office
Office européen des brevets

(11) Veröffentlichungsnummer: **0 089 575**
**A1**

# (12) EUROPÄISCHE PATENTANMELDUNG

(21) Anmeldenummer: 83102403.9

(22) Anmeldetag: 11.03.83

(51) Int. Cl.³: **H 01 L 29/28**
C 25 B 3/00, C 08 J 3/00
C 08 L 65/02, H 05 F 1/00
H 01 B 1/00

(30) Priorität: 23.03.82 DE 3210546

(43) Veröffentlichungstag der Anmeldung:
28.09.83 Patentblatt 83/39

(84) Benannte Vertragsstaaten:
BE DE FR GB NL

(71) Anmelder: BASF Aktiengesellschaft
Carl-Bosch-Strasse 38
D-6700 Ludwigshafen(DE)

(72) Erfinder: Wegner, Gerhard, Dr.
Hinterhofstrasse 46
D-7809 Denzlingen(DE)

(72) Erfinder: Eiffler, Juergen, Dr.
Reckholderbuehl 8
D-7700 Singen(DE)

(72) Erfinder: Wieners, Gerhard
Johann-von-Weerth-Strasse 15
D-7800 Freiburg(DE)

(72) Erfinder: Monkenbusch, Michael, Dr.
Sundgauallee 39
D-7800 Freiburg(DE)

(72) Erfinder: Naarmann, Herbert, Dr.
Haardtblick 15
D-6719 Wattenheim(DE)

(54) **Verfahren zur Herstellung elektrisch leitfähiger Oligophenyle, die nach dem Verfahren hergestellten Produkte und deren Verwendung.**

(57) Verfahren zur Herstellung von Oligophenylen mit hohen elektrischen Leitfähigkeiten durch elektrochemische Umsetzung von Oligophenylen und/oder niederomolekularen aromatischen Diazonium-Salzen mit einer ionisierbaren Verbindung des Typs $A^+B^-$ als Leitsalz, wobei $A^+$ ein Kation aus der Gruppe $H^+$, Alkalimetallion, Erdalkalimetallion, $R_4N^+$, $R_4P^+$, $NO^+$ und $NO_2^+$ sowie $B^-$ ein Anion aus der Gruppe $SbF_6^-$, $SbCl_6^-$, $AsF_4^-$, $AsF_6^-$, $PF_6^-$, $BF_4^-$, $SO_4^{2-}$, $ClO_4^-$, $SO_3CF_3^-$, Acetat⁻, Benzoat⁻ und Tosylat⁻ bedeuten und R ein Wasserstoffatom, ein aliphatischer, cycloaliphatischer oder aromatischer Rest ist. Nach diesem Verfahren werden elektrisch leitfähige Oligophenyle definierter Zusammensetzung mit eleketrischen Leitfähigkeiten über $14^{-4}\Omega^{-1}cm^{-1}$, insbesondere über $10^{-2}\Omega^{-1}cm^{-1}$ erhalten.

EP 0 089 575 A1

Croydon Printing Company Ltd.

Verfahren zur Herstellung elektrisch leitfähiger Oligophenyle, die nach dem Verfahren hergestellten Produkte und deren Verwendung

Die Erfindung betrifft ein Verfahren zur Herstellung von Oligophenylen definierter Zusammensetzung mit hoher elektrischer Leitfähigkeit durch Dotieren von Oligophenylen mit Elektronenakzeptoren und/oder -donatoren. Die Erfindung betrifft ferner die so hergestellten elektrisch leitfähigen Oligophenyle sowie deren Verwendung in der Elektroindustrie und zur antistatischen Ausrüstung von Kunststoffen.

Aus der EP-A2-36118 ist es bekannt, die elektrische Leitfähigkeit von konjugierten Polymeren durch elektrochemische Dotierung zu erhöhen. Hierzu werden die konjugierten Polymere als Anode und/oder Kathode einer elektrolytischen Zelle eingesetzt, wobei der Elektrolyt eine ionisierbare Verbindung enthält, die in ein oder mehrere ionische Dotierungsmittel ionisiert werden kann. Als konjugierte Polymere sind beispielsweise auch Polyphenylene genannt. Über die elektrochemische Dotierung von niedermolekularen oligomeren Systemen sind in dieser Patentanmeldung keine Angaben gemacht.

Das Dotieren von Polyphenylenen zur Herstellung von elektrisch leitfähigen Substanzen ist ebenfalls in der EP-A1-16305 beschrieben. Unter Polyphenylenen werden gemäß dieser Druckschrift auch Oligomere, zum Beispiel Quaterphenyl, verstanden, wobei deren Löslichkeit und bessere Verarbeitbarkeit als Vorteile herausgestellt sind. Auch wenn in der Beschreibung neben dem bloßen Abmischen der Komponenten und der Umsetzung der Polyphenylene mit den Dotierungsmitteln in der Gasphase, in Lösung oder in der Schmelze die elektrochemische Reaktion als eine Möglichkeit zur Dotierung der Polyphenylene erwähnt ist, so wird in den Beispielen, die die Dotierung von Oligophenylen betreffen, ausschließlich chemisch in der Gasphase dotiert.

Es ist weiterhin bereits die elektrochemische Oxidation von kondensierten aromatischen Ringsystemen, wie Perylen, Fluoranthren, Pyren und Triphenylen, im Zusammenhang mit der Untersuchung der elektrischen Leitfähigkeit derartiger Systeme beschrieben worden (vgl. Angew. Chem. 93 (1981), 360 ff; Mol. Cryst. Liqu. Cryst. 62 (1980), 181 ff).

Ferner ist auch bekannt, niedermolekulare, d.h. monomere und oligomere nicht-kondensierte Phenyl-Verbindungen durch elektrochemische (anodische) Oxidation in hochkondensierte Produkte und Polymere zu überführen. So werden z.B. nach dem Verfahren der US-PS 3 547 790 aus niedermolekularen Aromaten, wie z.B. Benzol, Biphenyl oder Terphenyl, durch anodische Oxidation höhermolekulare Produkte mit gesteigerter elektrischer Leitfähigkeit erhalten. In entsprechender Weise werden auch elektrisch leitfähige Polypyrrole durch anodische Polymerisation von Pyrrol in Gegenwart von Leitsalzen hergestellt (vgl. z.B. J.C.S. Chem. Comm. 1979, 635 und J.C.S. Chem. Comm. 1979, 854).

Der Erfindung liegt die Aufgabe zugrunde, ein Verfahren zur Herstellung von Oligophenylen mit hohen elektrischen Leitfähigkeiten aufzuzeigen, das in einfacher und reproduzierbarer Weise durchzuführen ist und zu möglichst reinen oligomeren Produkten mit definierter Zusammensetzung führt.

Diese Aufgabe wird erfindungsgemäß dadurch gelöst, daß man Oligophenyle und/oder niedermolekulare aromatische Diazonium-Salze elektrochemisch, vorzugsweise anodisch, in Gegenwart von bestimmten, als Dotierungsmittel wirkenden Leitsalzen dotiert.

Gegenstand der Erfindung ist demzufolge ein Verfahren zur Herstellung von Oligophenylen mit hohen elektrischen Leitfähigkeiten durch Dotieren von Oligophenylen mit Elektronenakzeptoren und/oder Elektronendonatoren als Dotierungsmittel, welches dadurch gekennzeichnet ist, daß man Oligophenyle und/oder niedermolekulare aromatische Diazonium-Salze elektrochemisch, vorzugsweise anodisch, in einem organischen, polaren Lösungsmittel mit Verbindungen des Typs $A^+B^-$ als Leitsalz umsetzt, wobei $A^+$ ein Kation aus der Gruppe Alkalimetall$^+$, Erdalkalimetall$^+$, $H^+$, $R_4N^+$, $R_4P^+$, $NO^+$ und $NO_2^+$, sowie $B^-$ ein Anion aus der Gruppe $SbF_6^-$, $SbCl_6^-$, $AsF_4^-$, $AsF_6^-$, $PF_6^-$, $BF_4^-$, $SO_4^{2-}$, $ClO_4^-$, $SO_3CF_3^-$, Acetat$^-$, Benzoat$^-$ und Tosylat$^-$ bedeuten und R ein Wasserstoffatom, ein aliphatischer, cycloaliphatischer und/oder aromatischer Rest ist.

Nach dem erfindungsgemäßen Verfahren ist es nicht nur möglich, elektrisch leitfähige Oligophenyle herzustellen, deren elektrische Leitfähigkeitswerte im Vergleich zu den Ausgangsverbindungen um viele Größenordnungen gesteigert sind und in einem sehr großen Bereich variiert und bei guter Stromausbeute für das jeweils verwendete System in Abhängigkeit von Spannung und Dauer der Spannungseinwirkung gezielt und leicht reproduzierbar eingestellt werden können. Sondern es ist auf Grund dieses Verfahrens gleichzeitig möglich, elektrisch leitfähige Oligophenyle definierter Zusammensetzung und vergleichsweise hohen Reinheitsgrades zu erlangen. Es hat sich nämlich gezeigt, daß in dem erfindungsgemäßen Verfahren die anodische Oxidation in überwiegendem Maße eine Dotierung der Oligophenyle bewirkt und - wenn überhaupt - nur in untergeordnetem und geringem Ausmaß Kondensation und Polymerbildung auftreten. Die erhaltenen elektrisch leitfähigen Oligophenyle sind je nach Verfahrensführung im allgemeinen entweder pulverförmig und zumindest teilweise mikrokristallin oder fallen direkt in Form großer Kristalle an. Sie lassen sich in einfacher Weise verformen und verarbeiten, sind luft- und lagerstabil und eignen sich auf Grund ihrer allgemein guten Eigenschaften hervorragend zum Einsatz in Anwendungsgebieten der Elektrotechnik.

Als Einsatzstoffe für das erfindungsgemäße Verfahren dienen Oligophenyle und/oder niedermolekulare aromatische Diazonium-Salze.

Unter Oligophenylen werden dabei im Rahmen dieser Erfindung die linearen, nicht-kondensierten Phenylen-Oligomeren mit einer Gliederzahl unter 10 verstanden. Die Oligophenyle können sowohl in definierter, reiner Form, d.h. als Einzelindividuen, als auch in Form von Oligophenyl-Gemischen eingesetzt werden. Bei Einsatz von Oligomeren-Gemischen stellen die angegebenen Gliederzahlen die mittleren Gliederzahlen (Zahlenmittel) der Gemische dar. Die einzelnen Phenylen-Reste der Oligophenyle können in ortho-, meta- oder para-Stellung miteinander verknüpft sein. Bevorzugt sind die Oligophenyle, deren Phenylen-Reste ausschließlich bzw. zumindest überwiegend meta- und insbesondere para-verknüpft sind. Als besonders günstig haben sich für das erfindungsgemäße Verfahren die Oligophenyle mit einer Gliederzahl von 2 bis 8 erwiesen, wie Biphenyl, Terphenyl, Quaterphenyl, Quinquiphenyl und Sexiphenyl oder Oligophenyl-Gemische mit entsprechender mittlerer Gliederzahl. In den Oligophenylen können auch ein oder mehrere der Phenyl- bzw. Phenylenreste, beispielsweise durch Alkyl-Reste (vorzugsweise mit 1 bis 20 C-Atomen), Cycloalkyl-Reste (vorzugsweise mit 6 bis 12 C-Atomen), Arylreste (vorzugsweise mit 6 bis 12 C-Atomen), Alkoxy-Reste, Phenoxy-Reste oder Halogenatome substituiert sein. Die unsubstituierten Oligophenyle haben sich jedoch im allgemeinen als vorteilhaft erwiesen.

Als niedermolekulare aromatische Diazonium-Salze kommen insbesondere Verbindungen der allgemeinen Formel

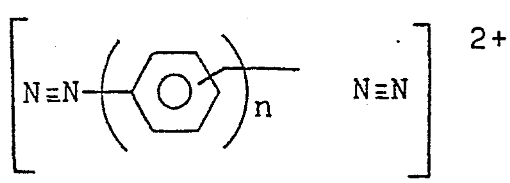 $X_2^-$

in Betracht, worin n eine ganze Zahl von 1 bis 8, insbesondere von 1 bis 4, und X ein geeignetes Gegenion, insbesondere $SO_4^{2-}$, $BF_4^-$, $Cl^-$ oder $ClO_4^-$, ist. Die beiden Diazonium-Gruppen können in ortho-, meta- oder para-Stellung angeordnet sein, vorzugsweise jedoch in meta- und insbesondere para-Stellung. Handelt es sich bei den Diazonium-Salzen um mehrgliedrige Phenylen-Verbindungen, so können die Phenylen-Glieder ortho-, meta- oder para-verknüpft sein, wobei die para-verknüpften Verbindungen bevorzugt sind. Als Beispiele für die erfindungsgemäß einzusetzenden niedermolekularen aromatischen Diazonium-Salze seien genannt p-Phenylen-bis-(diazonium)-dichlorid, p-Phenylen-bis-(diazonium)-sulfat, m-Phenylen-bis-(diazonium)-dichlorid, p-Biphenyl-bis-(diazonium)-dichlorid, Terphenyl-bis-(diazonium)-diperchlorat, Quaterphenyl-bis-(diazonium)-sulfat, Quinquiphenyl-bis-(diazonium)-sulfat, Sexiphenyl-bis-(diazonium)-tetrafluoroborat. Die Diazonium-Salze können in bekannter Weise aus den entsprechenden Diamin-Verbindungen hergestellt werden. Der bei der elektrochemischen Oxidation aus den Diazonium-Salzen freigesetzte Stickstoff wirkt als internes Schutzgas und erleichtert die Herstellung von sehr reinen Produkten.

Als Leitsalze, die gleichzeitig auch die Dotierungsmittel für die Oligophenyle darstellen, werden ionisierbare Verbindungen des Typs $A^+B^-$ eingesetzt, wobei es sich bei diesen ionisierbaren Verbindungen zweckmäßigerweise um ein einfaches Salz aus dem Kation $A^+$ und Anion $B^-$ handelt.

Das Kation $A^+$ kann dabei $H^+$, ein Alkalimetall-Kation, insbesondere $Li^+$, $Na^+$ oder $K^+$, ein Erdalkalimetall-Kation, insbesondere $Mg^{2+}$, $Ca^{2+}$ und $Ba^{2+}$, $NO^+$, $NO_2^+$, $R_4N^+$ oder $R_4P^+$ sein, wobei R ein Wasserstoffatom, ein aliphatischer Rest, vorzugsweise mit 1 bis 6 C-Atomen, ein cycloaliphatischer Rest, vorzugsweise mit 6 bis 14 C-Atomen oder ein aromatischer Rest, vorzugsweise mit 6 bis 14 C-Atomen ist. Unter den Ammonium- und Phosphonium-Kationen sind insbesondere diejenigen bevorzugt, in denen R einen Alkylrest mit 1 bis 4 C-Atomen darstellt. Als Beispiele für Ammonium-Kationen seien neben dem $NH_4^+$-Ion insbesondere das Tetra-n-butyl-, das Tetra-isopropyl- sowie das Tetra-ethyl-ammonium-Kation genannt. Bei den Phosphonium-Kationen kommen den Triphenyl- und Tri-n-butyl-phosphonium-Kationen besondere Bedeutung zu. Besonders bevorzugte Kationen sind die Alkalimetall-Kationen sowie die Tetraalkylammonium-Kationen.

Das Anion $B^-$ kann $SbF_6^-$, $SbCl_6^-$, $AsF_4^-$, $AsF_6^-$, $PF_6^-$, $BF_4^-$, $SO_4^{2-}$, $ClO_4^-$, $SO_3CF_3^-$, Acetat$^-$, Benzoat$^-$ und Tosylat$^-$ sein. Bevorzugte Anionen sind $SbF_6^-$, $SbCl_6^-$, $AsF_6^-$, $PF_6^-$, $BF_4^-$, $SO_4^{2-}$ und $ClO_4^-$.

Je nach dem gewünschten Dotierungsgrad und den angestrebten elektrischen Leitfähigkeitswerten beträgt die Leitsalzkonzentration in dem Elektrolyt im allgemeinen 0,001 bis 10, vorzugsweise 0,01 bis 1, Mol pro Liter Lösungsmittel. Als Leitsalze geeignete ionisierbare Verbindungen sind z.B. Tetrabutylammonium-tetrafluoroborat, Tetrabutylammonium-perchlorat, $Bu_4N^+PF_6^-$, $Bu_4N^+AsF_6^-$, $Bu_4N^+SbF_6^-$, $NO^+SbF_6^-$, $NO_2^+SbF_6^-$, $NO^+AsF_6^-$, $NO_2^+AsF_6^-$, $NO^+PF_6^-$, $NO_2^+PF_6^-$, $NO^+BF_4^-$, $NO_2^+BF_4^-$, $NO^+ClO_4^-$, Tributylphos-

phonium-tetrafluoroborat, Tributylphosphonium-perchlorat, $Li^+ClO_4^-$, $K^+BF_4^-$, $HClO_4$ und $H_2SO_4$.

Das erfindungsgemäße Verfahren wird in Gegenwart einer organischen polaren Verbindung als Elektrolyt-Lösungsmittel durchgeführt, in dem das Leitsalz gelöst oder suspendiert ist. Wenn mit Wasser mischbare organische Lösungsmittel Einsatz finden, kann zur Erhöhung der elektrischen Leitfähigkeit eine geringe Menge an Wasser, im allgemeinen bis zu 3 Gew.%, bezogen auf das organische Lösungsmittel, zugesetzt werden, auch wenn in der Regel in einem wasserfreien System gearbeitet wird. Das Lösungsmittel selbst sollte aprotisch sein. Bevorzugte Elektrolyt-Lösungsmittel sind z.B. Ether, wie Ethylenglykoldimethylether, Diethylenglykoldimethylether, Tetrahydrofuran und Dioxan, Aceton, Dimethylformamid, N-Methylpyrrolidon, Dimethylsulfoxid, Acetonitril, Methylenchlorid oder Propylencarbonat. Die Lösungsmittel sind selbstverständlich so auszuwählen, daß sie in dem angewendeten Spannungsbereich stabil sind.

Das erfindungsgemäße Verfahren kann in einer einfachen, üblichen elektrolytischen Zelle oder Elektrolyse-Apparatur durchgeführt werden, bestehend aus einer Zelle ohne Diaphragma, zwei Elektroden und einer externen Stromquelle. Nach einer Ausführungsform der Erfindung ist es möglich, daß eine oder auch beide Elektroden, vorzugsweise jedoch die Anode, mit den zu dotierenden Oligophenylen beschichtet oder in sonst geeigneter Weise flächig fest mit diesen verbunden sind. Die geeignete Schichtdicke hierfür kann leicht ermittelt werden und liegt im allgemeinen im Bereich von einigen µm bis einigen mm, vorzugsweise jedoch unter 1 mm. Diese Verfahrensweise ist beispielsweise bei Einsatz der festen schwerer löslichen Oligophenyle höherer Gliederzahl sinnvoll, die dann in geeigneter Weise, beispielsweise zu Preßlingen, Filmen oder Folien, geformt und mit der Anode flächig verbunden werden, und führt zu pulverförmigen, mikrokristallinen Produkten. Die Elektroden können dabei beispielsweise aus Graphit sein. Im allgemeinen werden jedoch zur Durchführung des erfindungsgemäßen Verfahrens zwei Edelmetallelektroden, bevorzugt Platinelektroden, verwendet. Dabei ist es günstig, wenn zumindest die Anode, insbesondere aber beide Elektroden, flächig ausgebildet sind.

Gemäß einer anderen Verfahrensvariante werden die erfindungsgemäß einzusetzenden Oligophenyle und/oder niedermolekularen aromatischen Diazonium-Salze in dem Elektrolyt-Lösungsmittel gelöst oder dispergiert. Hierdurch wird sichergestellt, daß die erhaltenen Oligophenyle gleichmäßig und vollständig dotiert sind. Die Oligophenyle und/oder niedermolekularen aromatischen Diazonium-Verbindungen werden dabei im allgemeinen in Konzentrationen von 0,001 bis 5 Mol/l Lösungsmittel eingesetzt, vorzugsweise in gesättigter Lösung und/oder dispergierter Form. Die dotierten Produkte scheiden sich dabei im allgemeinen in Form von gut ausgebildeten Kristallen an der Anode ab.

Außer der erwähnten einfachen elektrolytischen Zelle ohne Diaphragma können auch andere Elektrolyseeinrichtungen für das erfindungsgemäße Verfahren Einsatz finden, beispielsweise Zellen mit Diaphragma oder solche mit Referenzelektroden zur exakten Potentialbestimmung. Auch kann die Messung der Strommenge (Asec) zweckmäßig sein.

Temperatur und Druck, unter denen die elektrochemische Dotierung durchgeführt wird, können in dem erfindungsgemäßen Verfahren in Abhängigkeit von dem jeweiligen System eingestellt und variiert werden. Normalerweise führt man die Reaktion bei Raumtemperatur durch. Es kann jedoch je nach System auch eine andere Temperatur gewählt werden, solange die Erstarrungstemperatur bzw. Siedetemperatur des Elektrolyt-Lösungsmittels nicht unter- bzw. überschritten wird. Im allgemeinen hat sich eine Reaktionstemperatur im Bereich von -40 bis +40°C als sehr vorteilhaft erwiesen. Auch wenn bei geeigneten Vorkehrungen unter Unter- oder Überdruck gearbeitet werden kann, wird das erfindungsgemäße Verfahren üblicherweise unter Normaldruck in Inertgas-Atmosphäre durchgeführt.

Als Stromquelle für den Betrieb der elektrolytischen Zelle, in der das erfindungsgemäße Verfahren durchgeführt wird, eignet sich jede Gleichstromquelle, wie z.B. eine Batterie, die eine hinreichend hohe elektrische Spannung liefert. Die Höhe der jeweils notwendigen Spannung hängt hauptsächlich von dem jeweiligen System (eingesetztes Oligophenyl und/oder niedermolekulares aromatisches Diazonium-Salz, Leitsalz, Lösungsmittel), dem gewünschten Dotierungsgrad und der angewendeten Verfahrensweise ab. Sie soll nicht unnötig hoch gewählt werden, um eine oxidative Kupplung der Oligophenyle unter Polymerbildung zu vermeiden. Zweckmäßig benutzt man eine Spannung im Bereich von etwa 1 bis 25 Volt; als besonders vorteilhaft haben sich Spannungen im Bereich von etwa 2 bis 12 Volt erwiesen. Die Dauer der Spannungseinwirkung hängt von der Höhe der angelegten Spannung, der Stromdichte und dem gewünschten Dotierungsgrad ab. Im allgemeinen läßt sich der gewünschte Dotierungsgrad innerhalb von einigen Stunden erreichen. Die Stromdichte liegt üblicherweise im Bereich von 0,05 bis 100 $mA/cm^2$, vorzugsweise im Bereich von 0,1 bis 20 $mA/cm^2$.

Die dotierten Oligophenyle können in einfacher Weise von der Anode, z.B. mechanisch oder durch Abspülen, abgetrennt oder aus der Elektrolyt-Lösung isoliert werden. Zur Entfernung von anhaftendem Leitsalz werden die erhaltenen dotierten Oligophenyle mit einem geeigneten Lösungsmittel gewaschen

und bei Temperaturen von 30 bis 150°C, vorzugsweise unter Vakuum getrocknet. Man erhält auf diese Weise im allgemeinen entweder Kristalle oder pulverförmige Substanzen, die zumindest teilweise eine mikrokristalline Struktur aufweisen. Die erhaltenen dotierten Oligophenyle sind elektrisch leitfähig und besitzen eine definierte Struktur bei vergleichsweise hohem Reinheitsgrad.

Durch das erfindungsgemäße Verfahren werden Anstiege in der elektrischen Leitfähigkeit von einigen Größenordnungen erzielt. Die Ausgangsleitfähigkeiten der undotierten Olgiophenyle liegen im allgemeinen unter $10^{-10}\Omega^{-1}cm^{-1}$. Die erfindungsgemäß hergestellten elektrisch leitfähigen Oligophenyle haben elektrische Leitfähigkeiten im allgemeinen größer als $10^{-4}\Omega^{-1}cm^{-1}$, wobei elektrische Leitfähigkeiten von $10^{-2}\Omega^{-1}cm^{-1}$ bis zu $10^{2}\Omega^{-1}cm^{-1}$ und mehr erzielt werden können. Die elektrische Leitfähigkeit wird durch Kontaktierung der Produkte mit Leitsilber und Messung nach der Zweipunkt-Methode bestimmt. Identische Ergebnisse erhält man durch Messung nach der Vierpunkt-Methode, wobei die Übergangswiderstände der Kontaktierung keine Rolle spielen können.

Die erfindungsgemäß hergestellten elektrisch leitfähigen Oligophenyle können zur Herstellung von Katalysatoren, Batterien, Schaltern, Halbleiter-Bauteilen und Solarzellen Einsatz finden. Die Produkte eignen sich auch beispielsweise zur antistatischen Ausrüstung von Kunststoffen.

Die nachfolgenden Beispiele erläutern die Erfindung. Die in den Beispielen genannten Prozente sind Mol.%. Die Ermittlung der Gliederzahlen (Kettenlänge der Oligophenyle) erfolgte durch Endgruppen-Analyse über IR-Bestimmung des Verhältnisses der monofunktionellen Phenyl-Endgruppe zur difunktionellen Phenylen-Mittelgruppe.

<u>Beispiele 1 bis 13</u>

In einer Elektrolysezelle mit zwei Platinelektroden (3 cm x 3 cm Größe; Elektrodenabstand 2 cm) wurden die Elektrolytlösungen, die in dem in der nachfolgenden Tabelle 1 angegebenen Lösungsmittel jeweils 0,01 % der jeweiligen aromatischen Verbindung und 0,02 % des jeweiligen Leitsalzes enthielten, 16 Stunden bei -30°C (Beispiele 1 bis 7) bzw. +25°C (Beispiele 8 bis 13) elektrolysiert (Spannung: 10 V, Stromstärke: 5 mA). Die erhaltenen Produkte hatten alle elektrische Leitfähigkeiten größer $10^{-1}\Omega^{-1}$ $cm^{-1}$.

In der Tabelle 1 bedeuten:

I p-Phenylen-bis(diazonium)-dichlorid
II p-Phenylen-bis(diazonium)-sulfat
III m-Phenylen-bis(diazonium)-dichlorid
IV p-Biphenyl-bis(diazonium)-dichlorid
V Terphenyl-bis(diazonium)-perchlorat
VI Quaterphenyl-bis(diazonium)-sulfat

Beispiele 14 bis 17

In einer Elektrolysezelle mit Graphit-Elektroden (Fläche ca. 3 $cm^2$) wurden jeweils ca. 150 mg der in Tabelle 2 angegebenen Oligophenyle in gleichmäßiger Schicht auf die Anode aufgepreßt (Schichtdicke ca. 0,7 mm). Als Elektrolyt-Lösungsmittel diente Methylenchlorid; die Leitsalz-Konzentration betrug 0,01 %. Die Elektrolyse wurde bei Raumtemperatur unter Anlegung einer Spannung von etwa 9 V durchgeführt. Die weiteren Angaben sind in Tabelle 2 zusammengefaßt.

Tabelle 1

| Beispiel | Lösungsmittel | niederm. aromat. Verbindung | Leitsalz | | Produkt |
|---|---|---|---|---|---|
| 1 | Acetonitril | ( 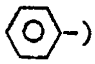 )$_2$ | $Bu_4N^+PF_6^-$ | 520 mg | rot |
| 2 | Acetonitril | ( 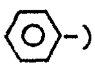 )$_3$ | $Bu_4N^+PF_6^-$ | 490 mg | dunkel-violett |
| 3 | Acetonitril | ( 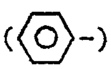 )$_4$ | $Bu_4N^+PF_6^-$ | 560 mg | schwarz-violett |
| 4. | Acetonitril | ( 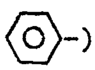 )$_{5-10}$ x | $Bu_4N^+PF_6^-$ | 540 mg | schwarzgrün |
| 5 | Methylenchlorid | I | $Et_4N^+ClO_4^-$ | 320 mg | schwarz |
| 6 | Dimethylformamid | II | $Et_4N^+ClO_4^-$ | 380 mg | schwarz |
| 7 | Dimethylformamid | III | $Et_4N^+AsF_6^-$ | 470 mg | schwarz |
| 8 | Acetonitril | ( 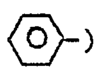 )$_{5-10}$ x | $Bu_4N^+PF_6^-$ | 570 mg | schwarz |
| 9 | Methylenchlorid | I | $Et_4N^+ClO_4^-$ | 380 mg | schwarz |
| 10 | N-Methyl-pyrrolidon | IV | $Bu_4N^+ClO_4^-$ | 320 mg | schwarz |
| 11 | N-Methyl-pyrrolidon | V | $Bu_4N^+ClO_4^-$ | 310 mg | schwarz |
| 12 | Dimethylsulfoxid | VI | $Li^+ClO_4^-$ | 590 mg | schwarz |
| 13 | Dimethylsulfoxid | IV | $K^+BF_4^-$ | 315 mg | schwarz |

x hergest. nach S.Hayma et al.; J.Pol.Sci, Polym.Chem.Ed. Vol. 12 (1974), S.357ff

Tabelle 2

| Beispiel | Oligophenyl | Leitsalz | Produkt elektr. Leitfähigk. $[\Omega^{-1}cm^{-1}]$ | Farbe |
|---|---|---|---|---|
| 14 | Oligophenyl-Gemisch (mittl.Gliederz. 7) | $Bu_4N^+BF_4^-$ | $5.10^{-3}$ | schwarz |
| 15 | Quaterphenyl | $Bu_4N^+BF_4^-$ | $10^{-3}$ | blauschwarz |
| 16 | Quaterphenyl | $Bu_4N^+AsF_6^-$ | $10^{-3}$ | blauschwarz |
| 17 | Quaterphenyl | $Bu_4N^+SbF_6$ | $10^{-2}$ | blauschwarz |

Patentansprüche

1. Verfahren zur Herstellung von Oligophenylen mit hohen elektrischen Leitfähigkeiten durch Dotieren von Oligophenylen mit Elektronenakzeptoren und/oder Elektronendonatoren als Dotierungsmittel, dadurch gekennzeichnet, daß man Oligophenyle und/oder niedermolekulare aromatische Diazonium-Salze elektrochemisch, vorzugsweise anodisch, in einem organischen, polaren Lösungsmittel mit Verbindungen des Typs $A^+B^-$ als Leitsalz umsetzt, wobei $A^+$ ein Kation aus der Gruppe $H^+$, Alkalimetallion, Erdalkalimetallion, $R_4N^+$, $R_4P^+$, $NO^+$ und $NO_2^+$ sowie $B^-$ ein Anion aus der Gruppe $SbF_6^-$, $SbCl_6^-$, $AsF_4^-$, $AsF_6^-$, $PF_6^-$, $BF_4^-$, $SO_4^{2-}$, $ClO_4^-$, $SO_3CF_3^-$, Acetat$^-$, Benzoat$^-$ und Tosylat$^-$ bedeuten und R ein Wasserstoffatom oder ein aliphatischer, cycloaliphatischer oder aromatischer Rest ist.

2. Verfahren nach Anspruch 1, dadurch gekennzeichnet, daß die eingesetzten Oligo-Phenyle eine Gliederzahl von 2 bis 8 besitzen.

3. Verfahren nach Anspruch 1, dadurch gekennzeichnet, daß man als niedermolekulares aromatisches Diazonium-Salz eine Verbindung der allgemeinen Formel

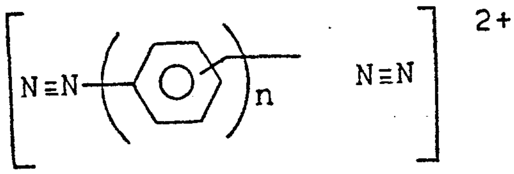

$X_2^-$

einsetzt, wobei n 1 bis 4 und X ein geeignetes Gegenion ist.

4. Verfahren nach Ansprüchen 1 bis 3, dadurch gekennzeichnet, daß das Leitsalz in einer Konzentration von 0,001 bis 10 Mol/l Lösungsmittel eingesetzt wird.

5. Verfahren nach Ansprüchen 1 bis 4, dadurch gekennzeichnet, daß die Oligophenyle und/oder niedermolekularen aromatischen Diazonium-Salze in dem Elektrolyt-Lösungsmittel gelöst oder dispergiert in einer Konzentration von 0,001 bis 5 Mol/l Lösungsmittel eingesetzt werden.

6. Verfahren nach Ansprüchen 1 bis 4, dadurch gekennzeichnet, daß die Oligophenyle und/oder niedermolekularen aromatischen Diazonium-Salze in als Feststoff mit der Anode verbundener Form eingesetzt werden.

7. Verfahren nach Ansprüchen 1 bis 6, dadurch gekennzeichnet, daß die elektrochemische Umsetzung mit einer Spannung im Bereich von 1 bis 25 Volt betrieben wird.

8. Elektrisch leitfähige Oligophenyle mit elektrischen Leitfähigkeitswerten größer als $10^{-4}\Omega^{-1}cm^{-1}$, hergestellt nach einem Verfahren gemäß Ansprüchen 1 bis 7.

9. Verwendung der elektrisch leitfähigen Oligophenyle, hergestellt nach einem Verfahren gemäß Ansprüchen 1 bis 7, in der Elektrotechnik, insbesondere zur Herstellung von Katalysatoren, Batterien, Schaltern, Halbleiter-Bauteilen und Solarzellen.

10. Verwendung der elektrisch leitfähigen Oligophenyle, hergestellt nach einem Verfahren gemäß Ansprüchen 1 bis 7 zur antistatischen Ausrüstung von Kunststoffen.

Europäisches Patentamt

# EUROPÄISCHER RECHERCHENBERICHT

0089575 Nummer der Anmeldung

EP 83102403.9

| EINSCHLÄGIGE DOKUMENTE | | | KLASSIFIKATION DER ANMELDUNG (Int. Cl. ³) |
|---|---|---|---|
| Kategorie | Kennzeichnung des Dokuments mit Angabe, soweit erforderlich, der maßgeblichen Teile | Betrifft Anspruch | |
| D,X | EP - A2 - 0 036 118 (UNIVERSITY)<br>* Seite 11, 2. Absatz; Seiten 14,15 *<br>-- | 1,4-9 | H 01 L 29/28<br>C 25 B 3/00<br>C 08 J 3/00<br>C 08 L 65/02<br>H 05 F 1/00<br>H 01 B 1/12 |
| X,P | EP - A1 - 0 047 903 (BASF)<br>* Gesamt; insbesondere Ansprüche; Beispiele 11,16 *<br>-- | 1,4,6-10 | |
| A | DE - A1 - 3 018 459 (BASF)<br>* Ansprüche *<br>-- | 1,2,8-10 | |
| D,A | EP - A1 - 0 016 305 (ALLIED CHEMICAL CORP.)<br>-- | | |
| D,A | US - A - 3 547 790 (DANNELS)<br>-- | | RECHERCHIERTE SACHGEBIETE (Int. Cl. ³) |
| D,A | MOLECULAR CRYSTALS AND LIQUID CRISTALS, Vol. 62, No. 1,2; 1980, New York<br>KELLER, NÖTHE, PRITZKOW, WEHE, WERNER: "Electrochemically Generated Peryleniumyl-Hexafluorophosphate and Hexafluoroarsenate: New One-Dimensional Metals" Seiten 181-199<br>-- | | H 01 L<br>C 08 G<br>C 08 L<br>C 08 J<br>C 25 B<br>H 05 F<br>H 01 B |

Der vorliegende Recherchenbericht wurde für alle Patentansprüche erstellt.

| Recherchenort | Abschlußdatum der Recherche | Prüfer |
|---|---|---|
| WIEN | 05-07-1983 | HEINICH |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

Europäisches Patentamt

# EUROPÄISCHER RECHERCHENBERICHT

0089575

Nummer der Anmeldung

EP 83102403.9

| EINSCHLÄGIGE DOKUMENTE | | | KLASSIFIKATION DER ANMELDUNG (Int. Cl.³) |
|---|---|---|---|
| Kategorie | Kennzeichnung des Dokuments mit Angabe, soweit erforderlich, der Maßgeblichen Teile | betrifft Anspruch | |
| D,A | JOURNAL OF THE CHEMICAL SOCIETY, Chemical Communications, 1, 1979<br>DIAZ, KANAZAWA "Electrochemical Polymerisation of Pyrrole"<br>Seiten 635,636<br>-- | | |
| D,A | JOURNAL OF THE CHEMICAL SOCIETY, Chemical Communications, 1, 1979<br>KANAZAWA, DIAZ, GEISS, GILL, KWAK, LOGAN, RABOLT, STREET "'Organic Metals': Polypyrrole, a Stable Synthetic 'Metallic' Polymer"<br>Seiten 854,855<br>---- | | RECHERCHIERTE SACHGEBIETE (Int. Cl.³) |

EPA Form 1503.2 06.78